# EUROPEAN PATENT APPLICATION

(11) **EP 4 572 043 A1**
(43) Date of publication of application: **18.06.2025**
(21) Application number: 24211389.2
(22) Date of filing: 07.11.2024
(51) Int. Cl.: H02B 1/28, H02B 1/44, H02B 1/46, H02G 3/08, H02G 3/14, H05K 5/06

(54) **ELECTRICAL BOX**

(30) Priority: 12.12.2023 IT 202300026490
(71) Applicant: E.T.A. S.p.A., 22035 Canzo (Como) (IT)
(72) Inventor: COSTAMAGNA, Andrea, COMO (IT)
(74) Representative: Zermani Biondi Orsi, Umberto

(57) **Abstract**

Electrical box (1) comprising a framework (2) having at least one flared side wall (16) and an opening (3) for access to a housing (4), a cover (5) comprising a peripheral inner frame (6), a corresponding plurality of fixing elements (9) comprising an insulation gasket (12) and configured to reversibly couple to respective first holes (7) obtained in the cover (5), and a sealing gasket (11) interposed between the cover (5) and the framework (2).

The electrical box (1) further comprises coupling means (8) configured to define a peripheral seat (10) with the inner frame (6) of the cover (5). The sealing gasket (11) being housed within the peripheral seat (10) so as to waterproof the housing (4).

## Description

The present invention relates to a box for housing electrical components.

In particular, the present invention preferably fits in the field of the food industry and/or in the medical field.

In other words, the box subject-matter of the present invention specifically fits in environments and/or departments which are periodically controlled, and thus require frequent sanitisation.

Depending on the hygiene protocols of each environment, the place where the electrical box is located can be sanitised daily, weekly or monthly.

The art known to date describes metal boxes comprising therein a containment compartment for switching, distribution and branch electrical components.

To limit the accumulation of dust or other contaminants, the boxes used in this specific area are free, as far as possible, of cracks and grooves.

For this purpose, the assembly of the box mainly involves welding between the various components that make it up. Thereby, constructive portions are eliminated which in their junction define cracks or joining spaces within which external agents can hide.

Disadvantageously, the boxes are therefore mainly made as one piece, i.e. the main components are permanently assembled together, which makes it impossible to replace the individual damaged or worn parts.

The boxes also have at least one access cover in the containment compartment, to allow any intervention on the electrical components.

In order to improve the waterproofing of the housing of the electrical components, in some boxes gaskets are provided between the cover and the containment framework that defines the inner compartment.

These gaskets are designed to prevent water vapours and moisture in general from accumulating over time along the inlets of the box, compromising the structure of the box itself as well as the electrical components present in the compartment.

The replacement of the gasket, in some cases, due to how the box was made, requires the entire cover to be changed.

In fact, the gasket is a structural component of the box that requires special maintenance, as it requires periodic replacement in order to prevent its damage and/or deterioration from compromising the functionality of the box.

In fact, if not replaced in time, the gasket no longer guarantees the insulation of the electrical components present in the housing of the box.

The passage of moisture inside the housing of the box would put the operation of the electrical components at risk, causing possible short circuits, and consequently putting at risk the people and objects in the environment to be sanitised.

Furthermore, disadvantageously the housing and the side surfaces of the box are places of accumulation of dust and dirt, which can jeopardize the integrity of the substantially sterile environment in which they are located.

Another problem found in this type of box is condensation, i.e. the liquid residue that hides on the horizontal surfaces of the bottom wall and the top wall.

Disadvantageously, the stagnant liquid compromises the structure of the box by chemically affecting the metal and deteriorating the surface of the box itself.

Furthermore, disadvantageously, condensation invalidates the correct sanitation and hygiene operations, increasing the formation of bacterial flora.

The technical task of the present invention is thus to make available an electrical box which is able to overcome the prior-art drawbacks which have emerged.

The object of the present invention is therefore to make available an electrical box capable of avoiding the retention of moisture, and facilitating the flow of fluids.

A further object of the present solution is therefore to make available an electrical box that is able to limit the deposit of dust and/or other polluting residues.

A further object of this solution is therefore to make available an electrical box that allows easy maintenance and therefore contained in economic terms.

Finally, a further object of the present solution is therefore to make available an electrical box that is able to efficiently isolate the electrical components housed inside it from the water vapours sprayed during the sanitisation of the environments.

The stated technical task and specified objects are substantially achieved by an electrical box comprising the technical features set forth in one or more of the appended claims.

According to one aspect of the present invention, an electrical box is made available.

The electrical box comprises a framework.

The framework defines a housing to accommodate electrical components. The framework has an opening for access to the housing.

The framework has at least one flared side wall configured to define a preferential flow path.

The electrical box comprises a cover.

The cover comprises a peripheral inner frame.

The electrical box further comprises a corresponding plurality of fixing elements.

The fixing elements are configured to reversibly couple with respective first holes obtained in the cover and the framework to maintain the inner frame in contact with the framework.

Each fixing element comprises a surface insulation gasket.

The cover defines in collaboration with the framework a use configuration and a maintenance configuration.

In the use configuration, the inner frame is in contact with the framework to occlude the opening of the framework through the coupling of the fixing elements in the plurality of first holes. In other words, in the use configuration the cover occludes the opening of the framework.

In the maintenance configuration, the plurality of first holes does not accommodate the plurality of fixing elements.

In the maintenance configuration the inner frame of the cover is spaced from the framework. In this way, in the maintenance configuration, the interior of the framework is accessible through the opening.

The electrical box comprises a sealing gasket interposed between the cover and the framework.

The electrical box further comprises coupling means reversibly fixed to the cover by means of the plurality of fixing elements.

The coupling means are configured to define a peripheral seat with the inner frame of the cover.

The sealing gasket is housed within the peripheral seat so as to waterproof the housing of the framework when the cover is in the use configuration.

Further characteristics and advantages of the present invention will appear clearer from the indicative, and therefore non-limiting, description of an electrical box.

Such description will be set forth herein below with reference to the accompanying drawings, provided for merely indicative and therefore non-limiting purposes, wherein:
- figure 1 shows a side section view of an electrical box according to the present invention;
- figure 2 shows a perspective view of an electrical box according to the present invention;
- figure 3 shows an exploded view of figure 2;
- figure 4 shows an exploded perspective view of a detail of an electrical box according to the present invention;
- figure 5 shows an exploded view of figure 1;
- figure 6 shows a zoom of a detail of an electrical box according to the present invention;

With reference to the attached figures, 1 indicates overall an electrical box for housing electrical components which, for simplicity of description, will be referred to below as an electrical box.

By electrical box 1 are meant power boxes inside which for example, switches and/or electrical panels are stored.

The electrical box 1 comprises a framework 2 defining a housing 4 used to receive electrical components and having an opening 3 for access to the housing 4.

The framework 2 of the electrical box 1 is preferably made mainly of stainless steel.

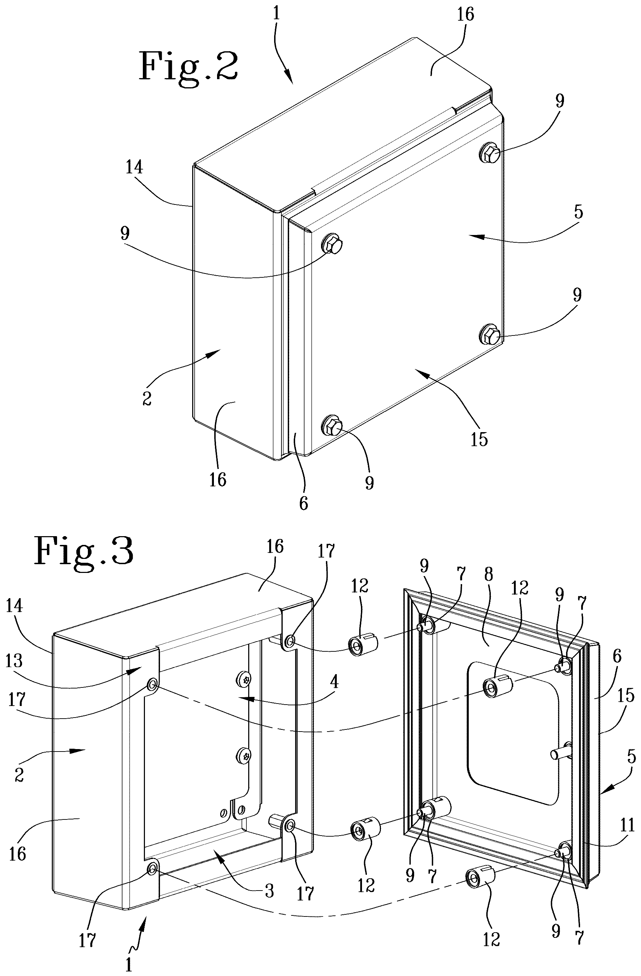

The framework 2, according to a possible embodiment shown in Figure 3, has an installation wall opposite the opening 3 and adjacent side walls, placed between the installation wall and the opening 3, configured to circumscribe the housing 4 of the framework 2.

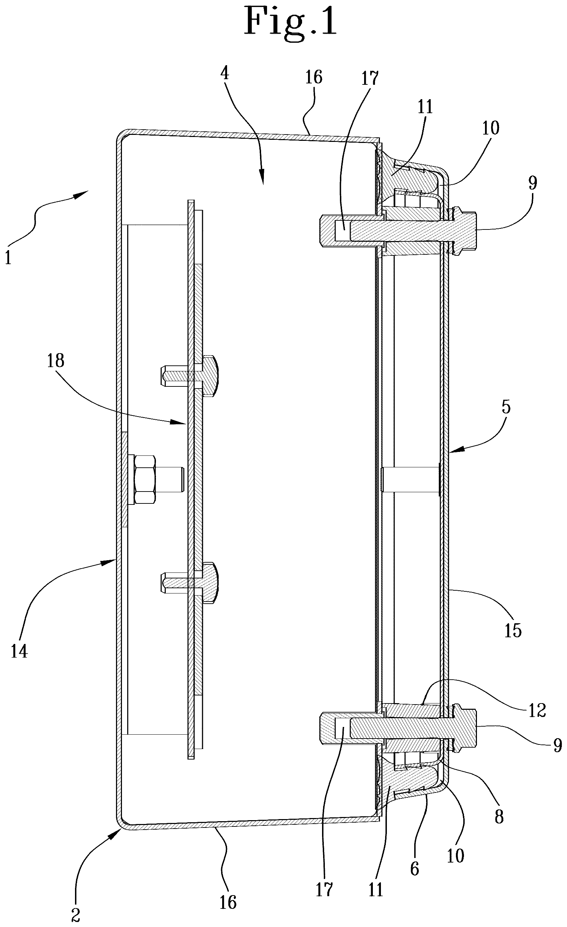

In the embodiment of the electrical box 1, shown in Figures 1-3 and 5, the installation wall is parallel to the opening 3.

The installation wall, as shown in Figure 1, comprises a plate 18 inside the housing 4 of the framework 2 configured to support electrical components.

According to a possible embodiment, the installation wall comprises a system of external fixing to the housing 4 of the framework 2, configured to fix the electrical box 1 to an outer element.

By outer element is meant, for example, a wall of an environment to be sanitised.

The external fixing system preferably has a circular shape and is made of stainless steel.

In the event that the installation wall comprises an external fixing system, the electrical box 1 is preferably placed vertically and hung on an outer element, for example a wall, with the opening 3 of the framework 2 opposite the outer element.

Still in order to support the electrical box 1, one of the side walls or the installation wall may comprise a plurality of adjustable rest feet outside the housing 4 of the framework 2.

The feet have threaded nuts according to a possible embodiment to facilitate coupling with the side wall.

In other words, depending on whether the electrical box 1 is suspended from the ground or rests on a plane such as a floor, the framework 2 will comprise respectively either an external fixing system on the installation wall or feet on the side wall.

The side walls are preferably four.

Even more preferably, the side walls are all equal to each other. In other words, the side walls have the same size and shape.

However, the shape and size of the side walls and of the electrical box 1 may be various and different from the attached figures.

The framework 2 has at least one flared side wall 16 configured to define a preferential flow path.

The term "flared" means that the wall is not horizontal, but has a given inclination.

Advantageously, the flared side wall 16 favours the outflow of water vapour residues and limits the deposit of dust and other contaminants.

According to a possible embodiment, the flared side wall 16 converges towards the opening 3 of the framework 2.

Preferably, at least one flared side wall 16 has a given angular inclination "G" with respect to the opening 3 of the framework 2.

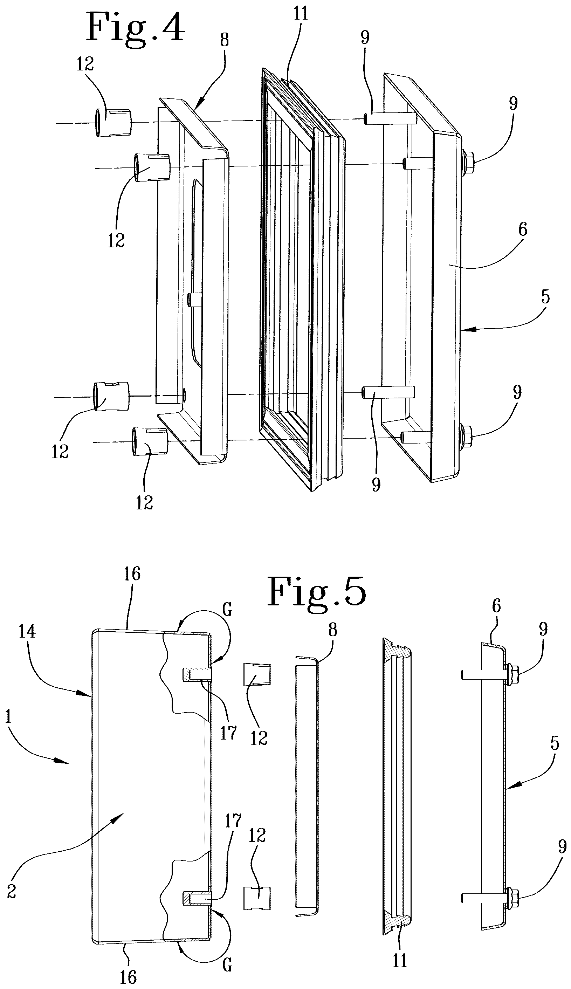

The given angular inclination "G", as shown in Figure 5, defines outside the framework 2 an angle of less than 270° between the at least one flared side wall 16 and the opening 3.

The electrical box 1 comprises a cover 5 comprising a peripheral inner frame 6.

The cover 5 is preferably made mainly of stainless steel.

The inner frame 6 projects inwardly towards the housing 4 of the framework 2.

In other words, the inner frame 6 develops perpendicularly with respect to the cover 5, in the direction of the opening 3 of the framework 2.

The electrical box 1 also comprises a corresponding plurality of fixing elements 9 configured to reversibly couple with respective first holes 7 obtained in the cover 5 and the framework 2 to maintain the inner frame 6 in contact with the framework 2.

The term "corresponding plurality" means the co-presence of an equal number of fixing elements 9 and first holes 7 in the electrical box 1.

The plurality of first holes 7 is preferably placed in the corners of the cover 5, as shown in Figure 3.

However, the position of the first holes 7 may be different from the attached figures.

The use of fixing elements 9 allows to avoid the irreversible welding of the components and thus, in the event of wear or damage, to allow the replacement of individual components, saving money on those parts which are still functioning, which can be disassembled with respect to the compromised piece and reused.

Preferably, the fixing elements 9 are made in the form of flat-headed threaded rivets.

Preferably, at least one fixing element 9 is made in the form of a flat-headed bolt.

Instead, according to a different embodiment, at least one fixing element 9 is made in the form of a flat-headed hexagonal screw, i.e. without an imprint.

The flat head of the threaded rivet and/or the bolt and/or the hexagonal screw, advantageously, allows to limit the accumulation of dust and other contaminants, which would otherwise be deposited in the notches present in the normal heads of the screws.

Each fixing element 9 comprises a surface insulation gasket 12. In this way, each fixing element 9 (i.e. each threaded rivet or bolt) is protected from possible contaminants that in any case are reduced or absent given the characteristics already described and still to be described of the cover 5 and the framework 2.

According to a possible embodiment, the insulation gasket 12 is made in the form of a tubular element wound on the surface of a respective threaded rivet (or bolt).

In other words, each threaded rivet is inserted into the tubular insulation gasket 12.

Advantageously, the insulation gasket 12 guarantees the waterproofing of the housing 4 of the framework 2, blocking the passage of liquids or water vapours that could hide between the plurality of first holes 7 and the fixing elements 9.

Preferably, the insulation gasket 12 is made of elastomeric material, in order to facilitate the insertion of the fixing element 9 inside the insulation gasket 12 itself.

According to a possible embodiment, the isolation gasket 12 comprises a spacer.

The spacer comprises fins configured to grip on the threads of the fixing elements 9.

The spacer is preferably made of rigid polymeric material.

The cover 5 defines in collaboration with the framework 2, thanks to the corresponding presence or absence of the fixing elements 9, a use configuration and a maintenance configuration.

In the use configuration the inner frame 6 is in contact with the framework 2 to occlude the opening 3 of the framework 2.

The occlusion of the opening 3 is guaranteed by the coupling between the fixing elements 9 and a plurality of first holes 7.

According to a possible embodiment, the framework 2 with the cover 5, in said use configuration, define a structure with a truncated pyramid shape.

Preferably, the framework 2 comprises a major base 14 defining the installation wall opposite the opening 3, while the cover 5 defines, in the use configuration, a minor base 15.

Major base 14 means a wall of the framework 2 with a greater extension than the extension of the minor base 15, i.e. of the cover 5.

In the maintenance configuration, on the other hand, the cover 5 is moved away from the opening 3 of the framework 2.

In other words, in the maintenance configuration the cover 5 and the framework 2 are spaced from each other, and the plurality of first holes 7 do not accommodate the plurality of fixing elements 9, leaving the opening 3 of the framework 2 free from engagements with other elements outside the framework 2 itself.

Advantageously, the opening 3 of the framework 2 in the maintenance configuration guarantees access to the electrical components kept inside the housing 4.

The electrical box 1 further comprises coupling means 8 reversibly fixed to the cover 5 by means of the plurality of fixing elements 9, and configured to define a peripheral seat 10 with the inner frame 6 of the cover 5.

The coupling means 8 are preferably made mainly of stainless steel. Advantageously, the fixing elements 9 ensure a secure mounting of the coupling means 8 to the cover 5, and since the fixing is reversible, they facilitate the maintenance of the individual components.

According to a possible embodiment, the coupling means 8 are circumscribed within the inner frame 6 of the cover 5.

The insulation gasket 12 of the fixing elements 9 is positioned, in the use configuration, between the framework 2 and the coupling means 8.

In other words, the tubular element is interposed, in use, between the framework 2 and the coupling means 8.

The electrical box 1 further comprises a sealing gasket 11 interposed between the cover 5 and the framework 2.

The sealing gasket 11 is housed within the peripheral seat 10 so as to waterproof the housing 4 of the framework 2 when the cover 5 is in the use configuration.

In other words, the sealing gasket 11 is configured to fit and expand between the coupling means 8 and the inner frame 6 of the cover 5.

Advantageously, the sealing gasket 11 isolates the housing 4 from the water vapours sprayed during the sanitisation of the environments in which the electrical box 1 is located.

Furthermore, advantageously, the sealing gasket 11, being interposed between the coupling means 8 reversibly fixed to the inner frame 6 of the cover 5, is easily removable from the rest of the aforementioned components and therefore replaceable in case of wear.

Advantageously, the spacer guarantees the reversible fixing of the assembly composed of the cover 5, the coupling means 8 and the sealing gasket 11, binding the fixing elements 9 to the assembly itself.

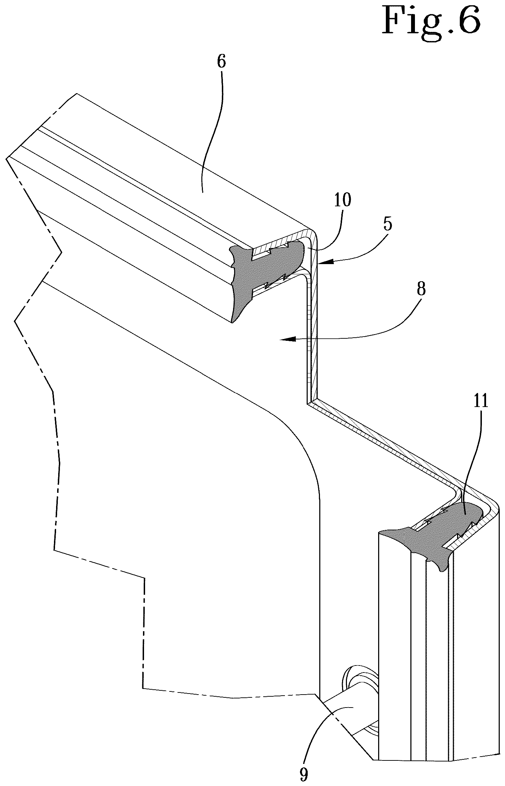

Preferably, as shown in Figure 6, the gasket has a portion insertable within the peripheral seat 10 having a dowel profile provided with one or more fins suitable for providing a reversible mating of the gasket in the peripheral seat 10.

The sealing gasket 11 can be made of elastomeric material, in order to facilitate its insertion in the peripheral seat 10.

Preferably, the sealing gasket 11 is mainly made of polymeric material.

Even more preferably, the sealing gasket is made of silicone material.

The framework 2 may further comprise, at the opening 3, a peripheral lip 13 configured to abut with the sealing gasket 11 when the cover 5 is in the use configuration.

The peripheral lip 13 acts as an inner counter-frame, filling the voids created between the cover 5 and the framework 2.

Advantageously, the peripheral lip 13 limits the passage of moisture inside the housing 4 of the framework 2 and prevents the deposit of dust and/or dirt in the areas surrounding the opening 3 of the framework 2.

The peripheral lip 13 may in turn comprise a plurality of second holes 17 aligned with the at least a plurality of first holes 7 when the cover 5 is in the use configuration.

The corresponding plurality of fixing elements 9 is configured to couple with the plurality of second holes 17.

According to a possible embodiment, the plurality of second holes 17 is made in the form of threaded holes into which each flat-head threaded rivet is screwed.

In other words, when the fixing elements 9 are inserted into the plurality of first holes 7, they are screwed until they meet and enter into screwing interaction also with the plurality of second holes 17, fixing the cover 5 to the framework 2.

Advantageously, the screwing of the fixing elements 9 into the plurality of first and second holes 7, 17 favours the insulation of the housing 4, keeping the cover 5 in a fixed and secure position with respect to the framework 2. In other words, the screwing of the fixing elements 9 to the plurality of first and second holes 7, 17 allows to obtain, in the configuration of use, a stable seal between the cover 5 and the framework 2 so as to guarantee the waterproofing of the housing 4.

The coupling means 8 may, in this case, have a plurality of third holes, in order to allow the passage of the fixing elements 9 through the plurality of first and second holes 7, 17.

In other words, in the event that the coupling means 8 are dimensionally obstructive for the passage of the fixing elements 9, the coupling means 8 can also have a plurality of third holes aligned with the first holes 7 of the cover 5 and with the second holes 17 of the framework 2, when the cover 5 and the framework 2 are in the use configuration.

Advantageously, the present invention makes available an electrical box 1 capable of overcoming the drawbacks arising from the prior art.

Advantageously, the present invention allows to avoid the retention of moisture, and to facilitate the flow of fluids inside the housing 4.

Advantageously, the present invention limits the deposition of dust and/or other polluting residues inside the housing 4.

Advantageously, the present invention makes available an electrical box 1 whose maintenance is facilitated and therefore contained in time and economic terms.

Advantageously, the present invention allows to efficiently isolate the electrical components housed inside the electrical box 1 from the water vapours sprayed during the sanitisation of the environments or from other unwanted external agents inside the housing 4.

## Claims

1. Electrical box (1) comprising:
- a framework (2) defining a housing (4) of electrical components and having an opening (3) for access to said housing (4);
- a cover (5) comprising a peripheral inner frame (6) defining, in cooperation with said framework (2), a use configuration in which said inner frame (6) is in contact with said framework (2) to occlude said opening (3) of said framework (2), and a maintenance configuration in which said cover (5) is distanced from said opening (3) of the framework (2);
- a plurality of fixing elements (9) configured to reversibly couple with respective first holes (7) obtained in the cover (5) and the framework (2) to maintain said inner frame (6) in contact with said framework (2) in the use configuration;
- a sealing gasket (11) interposed between the cover (5) and the framework (2);
- **characterised in that** it further comprises coupling means (8) reversibly fixed to said cover (5) by means of said plurality of fixing elements (9) and configured to define a peripheral seat (10) with said inner frame (6) of the cover (5);
each fixing element (9) comprising a surface insulation gasket (12);
said sealing gasket (11) being housed within said peripheral seat (10) so as to waterproof said housing (4) of the framework (2) when said cover (5) is in said use configuration;
and **in that** said framework (2) has at least one flared side wall (16) configured to define a preferential flow path.

2. Electrical box (1) according to the preceding claim, wherein said framework (2) and said cover (5) define, in said use configuration, a structure having a truncated pyramid shape.

3. Electrical box (1) according to claim 1 or 2, wherein said framework (2) comprises a major base (14) defining an installation wall opposite said opening (3); said cover (5) defining, in said use configuration, a minor base (15).

4. Electrical box (1) according to one or more of the preceding claims, wherein said at least one flared side wall (16) converges towards said opening (3) of the framework (2).

5. Electrical box (1) according to one or more of the preceding claims, wherein said at least one flared side wall (16) has a given angular inclination (G) with respect to said opening (3) of the framework (2), such that an angle less than 270° is defined outside said framework (2) between said at least one flared side wall (16) and said opening (2).

6. Electrical box (1) according to one or more of the preceding claims, wherein said framework (2) comprises at said opening (3) a peripheral lip (13) configured to abut with said sealing gasket (11) when said cover (5) is in said use configuration.

7. Electrical box (1) according to claim 6, wherein said peripheral lip (13) comprises a plurality of second holes (17) aligned with said at least one plurality of first holes (7) when said cover (5) is in said use configuration; said plurality of fixing elements (9) being configured to further couple with said plurality of second holes (17).

8. Electrical box (1) according to one or more of the preceding claims, wherein each fixing element (9) is made in the form of a flat-headed threaded rivet.

9. Electrical box (1) according to claims 7 and 8, wherein at least said plurality of second holes (17) is made in the form of threaded holes into which each flat-head threaded rivet is screwed.

10. Electrical box (1) according to claim 8 or 9, wherein said insulation gasket (12) is made in the form of a tubular element, each threaded rivet being inserted into said tubular insulation gasket (12), said tubular element being interposed between said framework (2) and said coupling means (8) when said cover (5) is in said use configuration.

11. Electrical box (1) according to one or more of the preceding claims, wherein said sealing gasket (11) and/or said insulation gasket (12) are made of elastomeric material.

12. Electrical box (1) according to one or more of the preceding claims, wherein said sealing gasket (11) has a portion insertable within said peripheral seat (10) and having a dowel profile provided with one or more fins suitable for providing a reversible mating of said sealing gasket (11) with said peripheral seat (10).

13. Electrical box (1) according to one or more of the preceding claims, wherein said coupling means (8) are circumscribed within the inner frame (6) of the cover (5).
